(19) Europäisches Patentamt
European Patent Office
Office européen des brevets

(11) EP 2 713 433 A1

(12) EUROPEAN PATENT APPLICATION

(43) Date of publication:
02.04.2014 Bulletin 2014/14

(51) Int Cl.:
H01M 10/48 (2006.01)        G01R 31/36 (2006.01)

(21) Application number: 13185515.7

(22) Date of filing: 23.09.2013

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME

(30) Priority: 28.09.2012  JP 2012216560

(71) Applicant: FUJITSU LIMITED
Kawasaki-shi,
Kanagawa 211-8588 (JP)

(72) Inventors:
• Ikeda, Kazuto
  Kanagawa, 211-8588 (JP)
• Kurita, Masanori
  Kanagawa, 211-8588 (JP)
• Watanabe, Masatoshi
  Kanagawa, 211-8588 (JP)
• Maruyama, Takashi
  Kanagawa  222-0033 (JP)

(74) Representative: HOFFMANN EITLE
Patent- und Rechtsanwälte
Arabellastrasse 4
81925 München (DE)

(54) State evaluation apparatus of secondary battery, state evaluation method of secondary battery, and computer-readable medium storing state evaluation program of secondary battery

(57)  A state evaluation apparatus of a secondary battery, the state evaluation apparatus includes at least one processor configured to perform a process including calculating internal resistance based on a measured voltage value and current value of the secondary battery and calculating internal temperature of the secondary battery and obtaining an amount of charge and discharge electric charge of the secondary battery based on the current value, or obtaining a charge state that indicates a charging rate of the secondary battery based on the current value and the voltage value, and calculating a battery state that indicates a state after deterioration of the secondary battery, based on the internal temperature and at least one of the amount of charge and discharge electric charge and the charge state.

FIG.1

**Description**

FIELD

The embodiment discussed herein is related to a state evaluation apparatus of a secondary battery, a state evaluation method of the secondary battery, and computer-readable medium storing a state evaluation program of the secondary battery.

BACKGROUND

A lot of technologies have been proposed in which a state of health (SOH) that indicates evaluation of a state of a secondary battery (hereinafter referred to as battery state) is estimated on the basis of a change in characteristics (voltage, current, and temperature) of the battery (for example, see Japanese Patent No. 4009537 and Japanese Patent No. 4548011). In the calculation of the battery state, the temperature of the battery is an important parameter. In these technologies, for example, temperature that is directly measured using a thermometer, or the like that is installed outside the battery is used.

SUMMARY

The external temperature that is measured by the thermometer that is installed outside the battery becomes an indication of the battery state. However, in an electric vehicle, current that flows through the battery changes rapidly in a short space of a time. In such an environment, in view of a heat capacity of a material that constitutes the battery and a distance between the inside and outside of the battery, a temperature change in an electrode portion that includes an active material inside the battery is barely reflected in a measurement value of the thermometer that is installed outside the battery. Therefore, the battery state is calculated on the basis of the external temperature of the battery, so that accuracy of the battery state is reduced.

Therefore, in the calculation of the battery state, it is desirable that temperature of a portion inside the battery, in which actual deterioration occurs (in particular, an electrode portion including the active material) is used. It is desirable that the temperature of the portion inside the battery is directly measured. However, in view of a structure, a technology, and cost of the battery, it is not easy to install the thermometer (sensor) inside the battery and measure the temperature inside the battery directly.

It is an object of the present embodiment to provide a state evaluation apparatus of a secondary battery, which highly accurately calculates a battery state of the secondary battery, a state evaluation method of the secondary battery, and computer-readable medium storing a state evaluation program of the secondary battery.

According to a first aspect of the embodiment, a state evaluation apparatus of a secondary battery, the state evaluation apparatus includes at least one processor configured to perform a process including calculating internal resistance based on a measured voltage value and current value of the secondary battery and calculating internal temperature of the secondary battery based on the current value, the internal resistance, and measured external temperature of the secondary battery and obtaining an amount of charge and discharge electric charge of the secondary battery based on the current value, or obtaining a charge state that indicates a charging rate of the secondary battery based on the current value and the voltage value, and calculating a battery state that indicates a state after deterioration of the secondary battery, based on the internal temperature and at least one of the amount of charge and discharge electric charge and the charge state.

BRIEF DESCRIPTION OF DRAWINGS

Fig. 1 is a diagram illustrating an example of a configuration of a state evaluation apparatus 10 of a secondary battery according to an embodiment.
Fig. 2 is a diagram illustrating an example of the further detailed configuration of the state evaluation apparatus 10 of the secondary battery according to the embodiment.
Fig. 3 is a diagram illustrating the overview of the calculation process of the battery state of the secondary battery in the calculation device 6-5 according to the embodiment.
Fig. 4 is a diagram to explain the measurement interval of the current value, the voltage value, and the surface temperature, and the calculation timing of the internal temperature and the battery state in the embodiment.
Fig. 5 is a flowchart illustrating the calculation process of the battery state of the secondary battery according to the embodiment.

Fig. 6 is a diagram to explain a calculation example of the internal resistance in the embodiment.

Fig. 7 is a diagram to explain change in internal temperature based on a temperature difference between the inside and outside of the secondary battery, which the heat transfer is considered.

Fig. 8 is a diagram illustrating an example of the effect of SOC, which is given to neglected deterioration.

DESCRIPTION OF EMBODIMENTS

The embodiments of the present invention are described below with reference to the accompanying drawings. Here, it is intended that the technical scope of the present invention is not limited to the embodiments but can cover items described in the scope of claims and their equivalents.

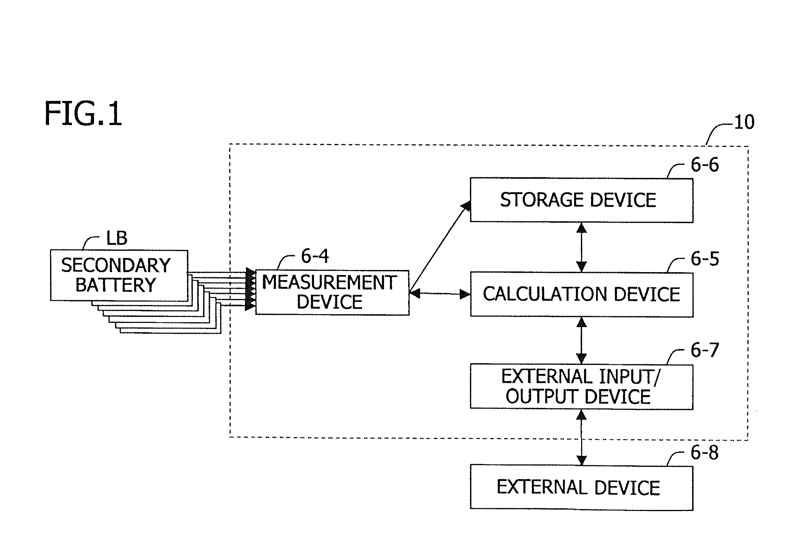

Configuration of a State Evaluation Apparatus of a Secondary Battery Fig. 1 is a diagram illustrating an example of a configuration of a state evaluation apparatus 10 of a secondary battery according to an embodiment. In Fig. 1, the state evaluation apparatus 10 of the secondary battery includes, for example, a measurement device 6-4, a storage device 6-6, a calculation device 6-5, and an external input/output device 6-7. The measurement device 6-4 is a device that measures a usage state and an environment parameter of a secondary battery LB. The measured information is stored in the storage device 6-6. In addition, the calculation device 6-5 calculates a battery state of each of the secondary batteries LB on the basis of the measurement value that is stored the storage device 6-6. The calculated battery state is output, for example, to an external device 6-8 through the external input/output device 6-7.

The secondary battery LB according to the embodiment is a rechargeable battery and a repeatedly usable battery. As an example of the secondary battery LB, there is a lithium ion the secondary battery. In addition, the battery state in the embodiment is in a state after deterioration, and in the embodiment, a state of an amount of electric charge that can be stored in the secondary battery LB (hereinafter referred to as storage enabled electric charge amount) is described. In the embodiment, the battery state is indicated, for example, by a ratio of a storage enabled electric charge amount at present time to an initial storage enabled electric charge amount.

Detailed Configuration of the State Evaluation Apparatus of the Secondary Battery

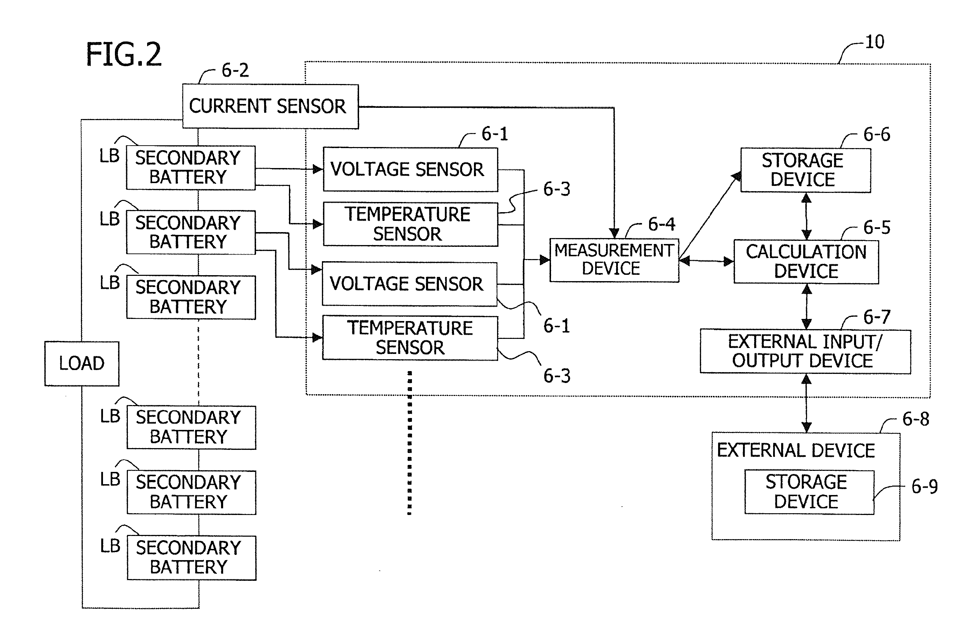

Fig. 2 is a diagram illustrating an example of the further detailed configuration of the state evaluation apparatus 10 of the secondary battery according to the embodiment. The measurement device 6-4 measures a voltage value, a current value, and an external temperature as a usage state and an environment parameter of the secondary battery LB, and stores the values and temperature in the storage device 6-6.

A voltmeter or a voltage sensor 6-1 is provided in order to allow the voltage value of the secondary battery LB to be measured. In addition, when all of the secondary batteries LB are connected to each other in series, an ammeter or a current sensor 6-2 is provided on a current line that connects the batteries. In addition, the current value of the secondary battery LB is measured by the current sensor 6-2. On the other hand, when all of the secondary batteries LB are connected to each other in parallel, a current value of the corresponding secondary battery LB is measured by the ammeter or the current sensor 6-2 that is provided for each parallel current line.

In addition, the external temperature is measured, for example, by providing a thermometer or a temperature sensor 6-3 on the surface of the secondary battery LB. In the embodiment, the external temperature indicates temperature of the surface of the secondary battery LB or temperature in the vicinity of the surface. In order to reduce an error in calculation of internal temperature, which is described later, it is desirable that temperature of the surface of the secondary battery LB is measured as the external temperature.

Generally, the measurement sensor outputs an analog signal. Therefore, the measurement device 6-4 converts the output analog signal into a digital signal by digital signal processing, or the like, and outputs the digital signal to the calculation device 6-5. In addition, the digital signal is stored in the storage device 6-6. The calculation device 6-5 performs various pieces of calculation on the basis of the digital signal, and calculates a battery state of the secondary battery LB.

The storage device 6-6 stores, for example, a program that is used to execute the various pieces of calculation that is executed by the calculation device 6-5, calculation result data, and the like in addition to digital signals of the measured usage state and environment parameter. In addition, the external input/output device 6-7 outputs, for example, the usage state, the environment parameter, the calculation result data, and the like to the external device 6-8 and obtains an instruction, data, and the like from the external device 6-8.

It is noted that the calculation device 6-5 may be connected to the storage device 6-6 through a wire, and may be connected to the storage device 6-6 through radio. In addition, the calculation device 6-5 may be connected to a storage device 6-9 in the external device 6-8 through the external input/output device 6-7. It is noted that, for each of the devices in the state evaluation apparatus 10 of Fig. 2, two or more may be provided depending on the type of calculation, or the like.

The overview of a calculation process of the battery state in the embodiment is described below with reference to the drawings.

Overview of the Calculation Process of the Battery State

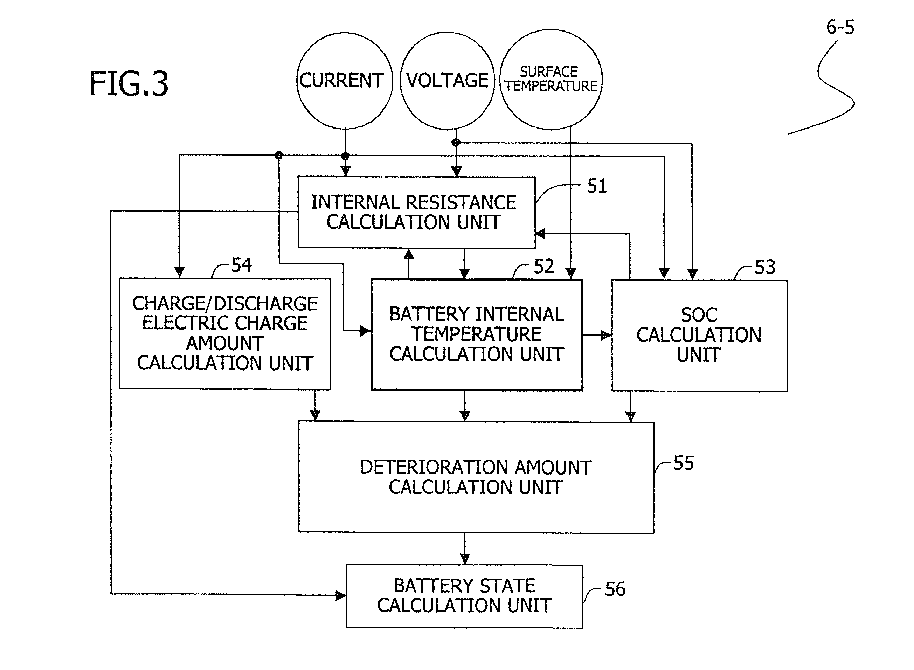

Fig. 3 is a diagram illustrating the overview of the calculation process of the battery state of the secondary battery in the calculation device 6-5 according to the embodiment. First, an internal resistance calculation unit 51 of the calculation device 6-5 calculates internal resistance on the basis of the current value and voltage value of the secondary battery, which are measured by the measurement device 6-4. In addition, a battery internal temperature calculation unit 52 calculates internal temperature to be estimated in the secondary battery, on the basis of the calculated internal resistance and the current value and surface temperature that are measured by the measurement device 6-4. In the embodiment, the internal temperature indicates temperature of one of or combination of an active material in a positive electrode and a negative electrode of the secondary battery, and an electrolyte of the secondary battery.

The internal temperature that is calculated by the battery internal temperature calculation unit 52 is used to calculate the battery state of the secondary battery. In the embodiment, the battery state of the secondary battery is calculated, for example, on the basis of neglected deterioration and charge and discharge cycle deterioration. Therefore, an SOC calculation unit 53 calculates a charge state that indicates a charging rate of the secondary battery (state of charge, hereinafter referred to as SOC). In addition, a deterioration amount calculation unit 55 calculates a degree of neglected deterioration on the basis of the internal temperature and the SOC. Alternatively, an amount of charge and discharge electric charge calculation unit 54 calculates an electric charge amount that is associated with charge and discharge of the secondary battery (hereinafter referred to as the amount of charge and discharge electric charge). In addition, the deterioration amount calculation unit 55 calculates a degree of cycle deterioration on the basis of the internal temperature and the amount of charge and discharge electric charge. A battery state calculation unit 56 calculates a battery state on the basis of the degree of neglected deterioration and the degree of cycle deterioration.

However, the battery state calculation unit 56 may calculate the battery state on the basis of one of the degree of neglected deterioration and the degree of cycle deterioration. In this case, one of the SOC or the amount of charge and discharge electric charge is calculated. However, the SOC calculation unit 53 may calculate the amount of charge and discharge electric charge in order to calculate the SOC independently of the amount of charge and discharge electric charge calculation unit 54. As described above, in the state evaluation apparatus 10 according to the embodiment, the internal temperature of the secondary battery is calculated. In addition, the state evaluation apparatus 10 highly accurately calculates a battery state using the calculated internal temperature and the SOC or the amount of charge and discharge electric charge.

Measurement Interval and Calculation Timing

Here, an interval in which a current value, a voltage value, and surface temperature are measured, and timing at which internal temperature and a battery state of the secondary battery are calculated in the embodiment are described.

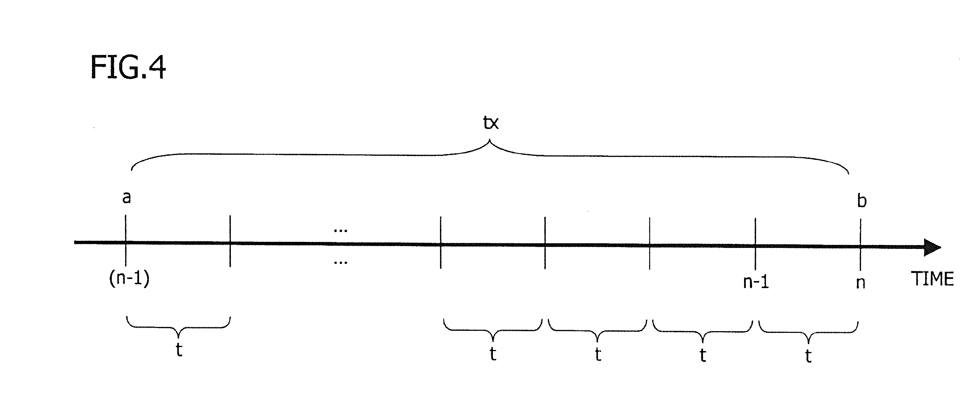

Fig. 4 is a diagram to explain the measurement interval of the current value, the voltage value, and the surface temperature, and the calculation timing of the internal temperature and the battery state in the embodiment. In the embodiment, the current value, the voltage value, and the surface temperature are measured for each time period "t". In addition, the calculation device 6-5 can calculate the internal temperature and the battery state on the basis of the measurement data for each of the time periods "t". In addition, in the embodiment, "n" indicates a measurement round that is a target, and "n-1" indicates a measurement round at a previous time. In addition, "a" indicates a calculation round in which the battery state is calculated at the previous time (calculation round "n-1" at the previous time of the battery state), "b" indicates a calculation round "n" that is a calculation target of the battery state. For example, the battery state in the calculation round "b" is calculated on the basis of the SOC and the amount of charge and discharge electric charge in a time period "tx" from the calculation round "a" to the calculation round "b".

In addition, the time period "t" that indicates a measurement interval can be set at a value by which current change can be appropriately grasped. When the secondary battery is mounted on an electric vehicle, for example, the time period "t" is set at a range from one millisecond to 10 seconds. This is why current that flows through the battery changes rapidly in a short space of a time. On the other hand, when the secondary battery is mounted on a machine in which current changes gradually, the time period "t" may be set, for example, at 10 seconds or more. In addition, as the time period "t" becomes short, an amount of the measurement data increases. Therefore, the time period "t" may be set on the basis of a balance with the data amount.

It is noted that the calculation of the battery state may not always be performed for each of the time periods "t". For example, the internal temperature is calculated for each of the time periods "t", and the battery state may be calculated not for each of the time periods "t" but at timing of the calculation round "b" after the calculation round "a" at the previous time through the plurality of time periods "t".

The calculation process of the battery state of the secondary battery is described in detail below.

Detailed Calculation Process of the Battery State

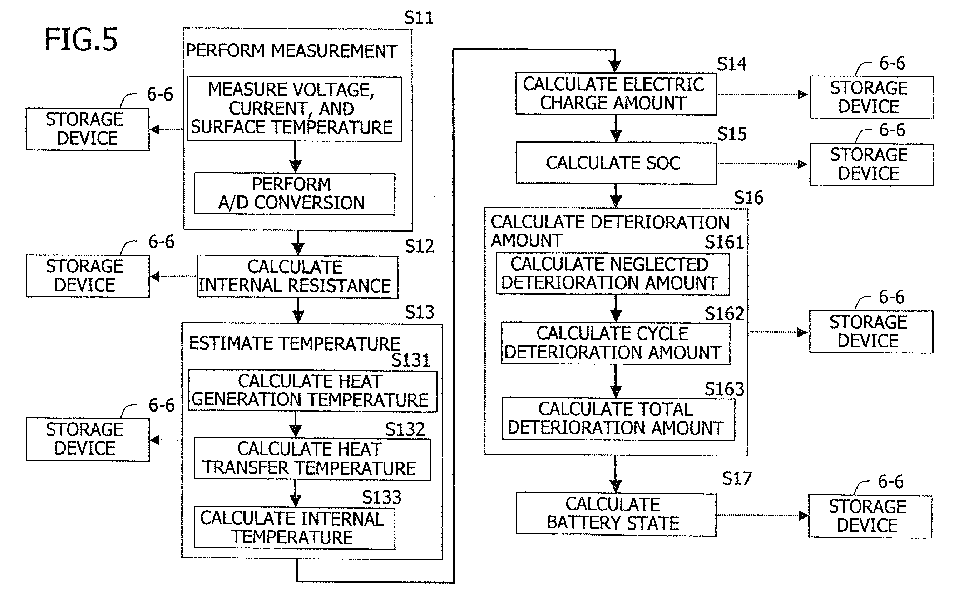

Fig. 5 is a flowchart illustrating the calculation process of the battery state of the secondary battery according to the embodiment. Here, an electric charge amount calculation step (S14) and an SOC calculation step (S15) may be executed prior to an internal resistance calculation step (S12) and may be executed between the internal resistance calculation step (S12) and a temperature estimation step (S13). It is noted that, in this example, a case is described in which a calculation process of the battery state of the single secondary battery is executed. When the battery states of the plurality of secondary batteries are calculated, for example, the state evaluation apparatus 10 may executes the calculation process of the battery state by a plurality rounds, or the plurality of state evaluation apparatuses 10 may execute the calculation process of the battery state in parallel.

In addition, a case is exemplified in which the calculation processes in the steps in Fig. 5 are executed in the single calculation device 6-5 of the state evaluation apparatus 10 according to the embodiment. However, the embodiment is not limited to such a case. The calculation processes in the steps may be executed in different calculation devices, and the calculation process in the single step may be executed by a plurality of calculation devices.

First, a voltage value, a current value, and surface temperature of the secondary battery are measured (S11). The measured values are converted into digital signals by an A/D conversion unit and stored in the storage device 6-6. After that, the calculation device 6-5 calculates internal resistance of the battery (S12).

Calculation of the Internal Resistance

In the embodiment, the internal resistance is calculated, for example, on the basis of the measured voltage value and current value. In particular, in the embodiment, the internal resistance is calculated on the basis of information on a plurality of sets of the measured voltage value and current value that are measured for the single secondary battery. When the internal resistance is calculated at the time of the measurement round "n", sets for the appropriate number of rounds of the previous measurement rounds (n-1 round, n-2 round, ...) are selected for the measurement round "n". On the other hand, when the internal resistance at the time of the measurement round "n" is calculated after repeating the measurement as time goes on after the measurement round "n", sets for the appropriate number of measurement rounds from the past to the future (..., round "n-2", round "n-1", round "n", round "n+1", round "n+2", ...) using the measurement round "n" as a reference can be selected. The number of sets is determined depending on the number of sets that can be used at the time of the calculation, calculation accuracy of the internal resistance, and a time that is desired for the calculation. The calculated internal resistance is stored in the storage device 6-6 and read by a subsequent calculation process.

In addition, need for the execution of internal resistance calculation may be determined on the basis of the SOC at that time. For example, when the SOC is small, it is probable that the calculated internal resistance has an error. Therefore, for example, when the SOC is small, it is determined that the calculation process of the internal resistance is not executed in order to avoid an error. In this case, for example, any of values of the internal resistance that has been calculated in the past is diverted or a value that is obtained on the basis of an equation using a plurality of pieces of internal resistance that have been calculated before is applied.

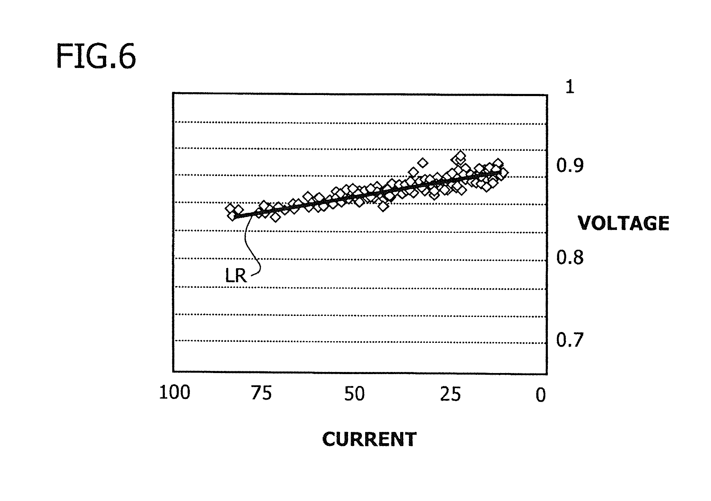

Fig. 6 is a diagram to explain a calculation example of the internal resistance in the embodiment. In Fig. 6, the vertical axis indicates voltage, and the horizontal axis indicates current. In Fig. 6, in order to calculate the internal resistance of the secondary battery that is a target, the appropriate number of sets of a voltage value and a current value is plotted. A straight line LR in Fig. 6 is an approximation straight line that is calculated on the basis of a correspondence relationship of the plotted voltage values and current values. In this example, the slope of the straight line LR indicates a value of the internal resistance. The straight line LR is obtained, for example, by performing straight line approximation by a data analysis method such as a least square method.

In the embodiment, for example, a calculation program that is used to obtain the slope of approximation straight line on the basis of the sets of the voltage values and current values is stored in the storage device 6-6 beforehand. In addition, the calculation device 6-5 reads the information on the plurality of sets of voltage values and current values and calculates the calculated slope of approximation straight line as the internal resistance in accordance with the calculation program. It is noted that the calculation program may be read out, for example, from the external device 6-8 through the external input/output device 6-7.

It is noted that a method of obtaining the internal resistance is not limited to such a case. For example, the internal resistance may be obtained on the basis of a plurality of voltage values that are obtained by causing pulsed short time current that has a plurality of given current amounts to flow. In addition, the plurality of different methods of calculating the internal resistance may be used so as to be switched by the SOC at that time.

Calculation of the Internal Temperature

Returning to the flowchart of Fig. 5, the calculation device 6-5 calculates the internal temperature in the secondary battery on the basis of the internal resistance that is calculated in the step S12, the current value, and the surface temperature of the secondary battery (S13). In the embodiment, the calculation device 6-5 calculates the internal temperature of the secondary battery on the basis of internal temperature change (heat generation temperature) based on a heat amount in accordance with the measured current value and internal temperature change (heat transfer temperature) based on heat transfer due to a temperature difference between the inside and outside of the battery. First, a calculation process of internal temperature change based on a heat amount in accordance with the current value is described.

Calculation of the Internal Temperature Change Based on Heat Amount

First, the calculation device 6-5 calculates heat generation temperature on the basis of the measured current value and the calculated internal resistance (S131). The following equation 1 is a common equation that is used to calculate Joule heat E (heat amount) depending on current. As represented in the equation 1, the Joule heat E is a heat amount when a current value I flows through an object of electrical resistance R, and is obtained by multiplying the square of the current value I by the internal resistance R.

$$E = R * I^2 \quad \text{(equation 1)}$$

Therefore, the calculation device 6-5 calculates internal temperature change based on a heat amount depending on the current value as heat generation temperature, on the basis of the following equation 2. The left side of the equation "$\Delta T^H_{n-1 \to n}$" in the equation 2 represents internal temperature change that is obtained on the basis of a heat amount that is generated in the time period "t" from the measurement round "n-1" to the measurement round "n". In addition, in the equation 2, "$Ri_{n-1}$" is internal resistance that is calculated on the basis of measurement data of the measurement round "n-1" at the previous time, and "$Ri_n$" is internal resistance that is calculated on the basis of measurement data of the measurement round "n" at this time. Therefore, "$\{(Ri_{n-1}+Ri_n)/2\}$" represents an average value of the internal resistance in the time period "t" at the measurement round "n-1" and the measurement round "n". Similarly, "$\{(I_{n-1}+I_n)/2\}$" represents an average value of current in the time period "t".

$$\Delta T^H_{n-1 \to n} = a * \{(Ri_{n-1}+Ri_n)/2\} * \{(I_{n-1}+I_n)/2\}^2 * t \quad \text{(equation 2)}$$

As described above, in the embodiment, the average value of values of the measurement round "n-1" and the measurement round "n" is used for the calculation process as a value in the time period "t" at the measurement round "n". As described above, by using the average value in the period "t" even when there is large variation in each of the values, an appropriate value for which the variation amount is considered is used for the calculation. As a result, accuracy of the calculated internal temperature and battery state becomes high. However, the embodiment is not limited to such a case, and the values of the measurement round "n-1" or the measurement round "n" may be directly used as a value in the time period "t", depending on circumstances.

In the equation 2, the equation 1 is further multiplied by the time period "t" and a coefficient "$\alpha$". By multiplying the equation 1 by the time period "t", the Joule heat is converted into a heat amount when current $\{(I_{n-1}+I_n)/2\}$ flows during the time period "t". In addition, the coefficient "$\alpha$" is a value that is used to convert a heat amount into temperature, and a value that reflects a heat characteristic such as a heat capacity of the secondary battery. By multiplying the heat amount by the coefficient "$\alpha$", temperature that rises in accordance with the heat amount when the current "$\{(I_{n-1}+I_n)/2\}$" temperature flows during the time period "t", that is, internal temperature change is calculated.

It is noted that the coefficients "$\alpha$" are different depending on a material and a configuration of the secondary battery. Therefore, the coefficient "$\alpha$" is a value that is set on the basis of an experimental value beforehand. In addition, in the secondary battery, an individual difference between characteristics occurs depending on variation of the material and the manufacturing process. Therefore, it is desirable that the coefficient "$\alpha$" is further adjusted in accordance with the individual difference. By setting the coefficient "$\alpha$" at an appropriate value, accuracy of the calculated internal temperature change is improved. This means that accuracy of the battery state of the secondary battery, which is calculated on the basis of the internal temperature is also improved.

In particular, when the secondary battery state that is calculated by the state evaluation apparatus 10 according to the embodiment is different from a battery state that is obtained by electrical measurement (charge and discharge characteristic evaluation, terminal open voltage measurement, or the like) (hereinafter, referred to as a measured battery state), it is indicated that one of the factors is that the coefficient "$\alpha$" is not set at the appropriate value. In particular, for example, when the calculated battery state change is smaller than an actual battery state change, it is indicated that one of the factors is that the temperature change based on the heat amount is underestimated. This indicates that, for example, the value of the coefficient "$\alpha$" is smaller than the appropriate value.

As described above, in a step S131, the internal temperature change $\Delta T^H_{n-1 \to n}$ based on the heat amount, that is, internal elevated temperature due to heat is calculated. After that, secondly, the calculation device 6-5 calculates internal temperature change based on heat transfer due to a temperature difference between the inside and outside of the secondary battery (S132).

Calculation of the Internal Temperature Change Based on Heat Transfer due to a Temperature Difference between the Inside and Outside of the Secondary Battery

The following equation 3 is an equation that is used to calculate internal temperature change based on heat transfer due to the temperature difference between the inside and outside of the secondary battery. The left side of the equation "$\Delta T^T_{n-1 \to n}$" in the equation 3 represents internal temperature change based on heat transfer in the time period "t" from the measurement round "n-1" to the measurement round "n". When the internal temperature of the battery is higher than the surface temperature, the heat transfer from the inside to the outside of the battery occurs. Therefore, the internal temperature change "$\Delta T^T_{n-1 \to n}$" becomes a negative value. On the other hand, when the surface temperature of the battery is higher than the internal temperature of the battery, the heat transfer from the outside to the inside of the battery occurs. Therefore, the internal temperature change "$\Delta T^T_{n-1 \to n}$" becomes a positive value. In the equation 3, "$\{(Ts_{n-1}+Ts_n)/2\}$" is the average surface temperature in the time period "t", and $T_{n-1}$ is the internal temperature that is calculated at the previous time by the state evaluation apparatus 10 according to the embodiment.

$$\Delta T^T_{n-1 \to n} = \{(Ts_{n-1}+Ts_n)/2\} - \{(Ts_{n-1}+Ts_n)/2 - (T_{n-1}+\Delta T^H_{n-1 \to n}/2)\} * \exp(-\beta t) - T_{n-1}$$

(equation 3)

First, the portion calculation formula "$\{(Ts_{n-1}+Ts_n)/2 - (T_{n-1}+\Delta T^H_{n-1 \to n}/2)\} * \exp(-\beta t)$" in the equation 3 is described. The portion calculation formula is a temperature difference between the surface temperature of the secondary battery and the internal temperature in which the temperature change based on the heat amount is considered, and indicates a temperature difference in which the heat transfer is considered. "$\Delta T^H_{n-1 \to n}$" in the portion calculation formula represents internal temperature change based on the heat amount depending on the current that is calculated in accordance with the above-described equation 2, and "$\Delta T^H_{n-1 \to n}/2$" represents average internal temperature change in the time period "t". By adding the internal temperature change $\Delta T^H_{n-1 \to n}/2$ based on the heat amount in the time period "t" to the internal temperature $T_{n-1}$ that is calculated at the previous time, internal temperature in which the temperature change based on the heat amount is considered is calculated.

Therefore, "$\{(Ts_{n-1}+Ts_n)/2 - (T_{n-1}+\Delta T^H_{n-1 \to n}/2)\}$" that is a part of the portion calculation formula represents a temperature difference between the surface temperature and the internal temperature in which the temperature change based on the heat amount is considered. When the temperature difference is a negative value, it is indicated the heated internal temperature is higher than the surface temperature. On the other hand, when the temperature difference is a positive value, it is indicated that the surface temperature is higher than the heated internal temperature. This indicates, for example, a case in which the secondary battery is provided in a high temperature environment.

In addition, by multiplying such a temperature difference "$\{(Ts_{n-1}+Ts_n)/2 - (T_{n-1}+\Delta T^H_{n-1 \to n}/2)\}$" by "$\exp(-\beta t)$", temperature difference in which the heat transfer is considered is calculated. The temperature difference between the inside and outside of the secondary battery has a characteristic in which the temperature difference exponentially decreases using a Napier's constant as a base for the time period "t". When the internal temperature is higher than the surface temperature of the battery, heat amount that occurs inside the battery due to the current is transferred to the outside of the battery. The internal temperature is reduced due to the heat transfer from the inside to the outside of the battery, and the temperature difference between the inside and outside of the battery exponentially decreases. That is, the temperature difference becomes zero ultimately, and the internal temperature becomes the same as the surface temperature. However, in the surface temperature at that time, surface temperature change in the time period "t" is considered, and "$(Ts_{n-1}+Ts_n)/2$" is obtained. As described above, by multiplying the temperature difference by "$\exp(-\beta t)$", a temperature difference in which a change characteristic of the heat transfer based on the time period "t" is reflected is calculated.

A coefficient "$\beta$" is a coefficient that indicates a moving speed of a heat amount in which a heat characteristic such as a heat capacity of the battery is reflected. The coefficient "$\beta$" is set by an experimental value beforehand. In addition, because an individual difference between characteristics occurs depending on variation of the material and the manufacturing process, it is desirable that the coefficient "β" is adjusted in accordance with the individual difference. In addition, similar to the coefficient "α", by setting the coefficient "β" appropriately, accuracy of calculated internal temperature change is improved. Therefore, accuracy of a battery state of the secondary battery, which is calculated on the basis of the internal temperature, is also improved.

When the battery state that is calculated in the state evaluation apparatus 10 and the actual battery state are different in the embodiment, it is indicated that one of the factors is that the coefficient "β" is not set at an appropriate value. For example, when the calculated battery state change is smaller than the actual battery state change, temperature reduction due to heat transfer is overestimated. This indicates the value of the coefficient "β" is larger than the appropriate value.

As described above, by the portion calculation formula "$\{(Ts_{n-1}+Ts_n)/2-(T_{n-1}+\Delta T^H_{n-1 \rightarrow n}/2)\}*\exp(-\beta t)$" in the equation 3, a temperature difference between the surface temperature and the internal temperature, in which the temperature change based on the heat amount is considered, that is, a temperature difference in which the heat transfer is considered is calculated. When the internal temperature is higher than the external temperature in the secondary battery, the calculated temperature difference becomes a negative value, and when the internal temperature is lower than the external temperature in the secondary battery, the calculated temperature difference becomes a positive value. In addition, in the equation 3, by further subtracting the calculated temperature difference from the surface temperature $\{(Ts_{n-1}+Ts_n)/2\}$, internal temperature based on the temperature difference between the inside and outside of the secondary battery, in which the heat transfer is considered is calculated.

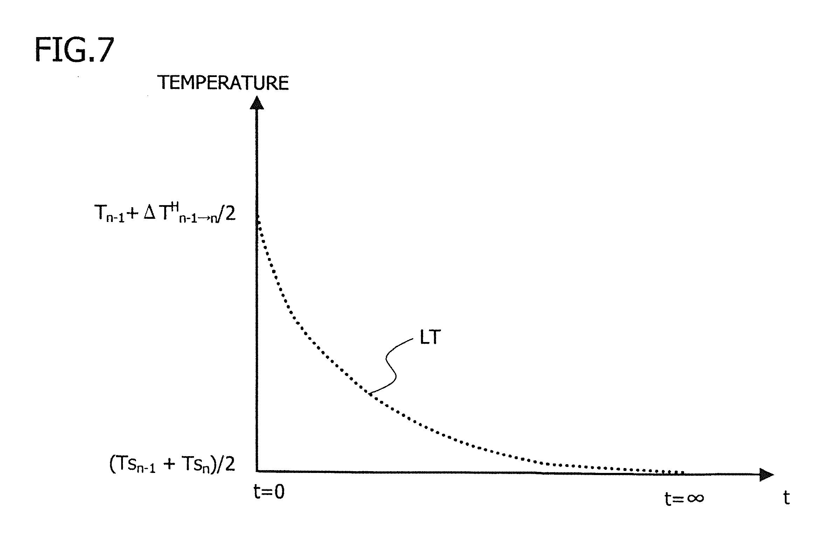

Fig. 7 is a diagram to explain change in internal temperature based on a temperature difference between the inside and outside of the secondary battery, which the heat transfer is considered. In Fig. 7, the horizontal axis indicates the time period "t", and the vertical axis indicates internal temperature. In addition, a curve LT indicates internal temperature that is calculated by the calculation formula "$\{(Ts_{n-1}+Ts_n)/2\}-\{(Ts_{n-1}+Ts_n)/2-(T_{n-1}+\Delta T^H_{n-1 \rightarrow n}/2)*\exp(-\beta t)$". In this example, a case is described in which the internal temperature of the secondary battery is higher than the external surface temperature. Therefore, as illustrated in the curve LT in Fig. 7, the internal temperature is reduced as the time period "t" becomes long because the battery internal temperature is transferred to the outside. In addition, as described above, the temperature difference between the inside and outside of the battery exponentially decreases as time continues.

For example, when it is assumed that "time period t=0" is set, "$\exp(-\beta t)=1$" is obtained, so that the internal temperature in Fig. 7 becomes "$(T_{n-1}+\Delta T^H_{n-1 \rightarrow n}/2)$". That is, the internal temperature when the time period "t" does not elapses at all is apparently regarded as temperature that is obtained by adding the elevated temperature "$\Delta T^H_{n-1 \rightarrow n}/2$" based on the heat amount to the internal temperature "$T_{n-1}$" at the previous time. This is why the rise of the internal temperature by "$\Delta T^H_{n-1 \rightarrow n}$" during the time period "t" is considered. On the other hand, for example, when "time period t=∞" is set, "$\exp(-\beta t)=0$" is obtained, so that the internal temperature that is the calculation result becomes "$\{(Ts_{n-1}+Ts_n)/2\}$". This indicates that the internal temperature is apparently intended to be close to the external temperature "$\{(Ts_{n-1}+Ts_n)/2\}$" as the time period "t" becomes long. This is why change of the surface temperature from "$Ts_{n-1}$" to "$Ts_n$" during the time period "t" is considered.

In addition, in the equation 3, the internal temperature "$T_{n-1}$" at the previous time is further subtracted from the internal temperature that is calculated by the calculation formula "$\{(Ts_{n-1}+Ts_n)/2\}-\{(Ts_{n-1}+Ts_n)/2-(T_{n-1}+\Delta T^H_{n-1 \rightarrow n}/2)\}*\exp(-\beta t)$" that is represented by the curve LT in Fig. 7. As a result, temperature change "$\Delta T^T_{n-1 \rightarrow n}$" from the previous time of the internal temperature based on the temperature difference between the surface temperature and the internal temperature in which the temperature change based on the heat amount is considered, that is, the temperature difference in which the heat transfer is considered. As described above, internal temperature change based on the heat transfer between the inside and outside of the secondary battery is calculated.

Addition of the Internal Temperature Change

In addition, the following equation 4 is an equation that is used to calculate internal temperature of the measurement round "n". The left side of the equation "$T_n$" in the equation 4 indicates internal temperature of the measurement round "n". In the equation 4, by adding internal temperature change in the time period "t" at this time, that is, internal temperature change "$\Delta T^H_{n-1 \rightarrow n}$" based on the heat amount (S131) and internal temperature change "$\Delta T^T_{n-1 \rightarrow n}$" based on the heat transfer due to the temperature difference between the inside and outside of the secondary battery (S132) to the internal temperature "$T_{n-1}$" at the previous time, internal temperature "$T_n$" of the measurement round "n" is calculated. For example, when the internal temperature is higher than the temperature of the surface portion in the battery, internal temperature change "$\Delta T^T_{n-1 \rightarrow n}$" based on the heat transfer becomes a negative value. In this case, it is indicated that the internal temperature change "$\Delta T^H_{n-1 \rightarrow n}$" that rises due to generation of heat and the internal temperature change "$\Delta T^T_{n-1 \rightarrow n}$" that is reduced due to the heat transfer are combined to each other.

$$T_n = T_{n-1} + \Delta T^H_{n-1 \to n} + \Delta T^T_{n-1 \to n} \quad \text{(equation 4)}$$

As described above, by using the internal temperature change based on the internal Joule heat of the secondary battery, which is obtained on the basis of the current value and the internal resistance and internal temperature change based on the heat transfer due to the temperature difference between the inside and outside of the secondary battery, the internal temperature is calculated. The calculated internal temperature "$T_n$" is used to calculate the battery state of the measurement round "n".

It is noted that, in a case in which there are a plurality of parts in which deterioration occurs in the secondary battery, the battery state may be calculated for each of the parts. In this case, for example, the internal temperature is also calculated for each of the parts. In the calculation of the internal temperature, it is desirable that the coefficient "$\alpha$" and the coefficient "$\beta$" that are used for the equations are set for each of the parts.

After that, in the steps of the second half of the flowchart in Fig. 5 (S14 to S17), the battery state of the secondary battery is calculated using the calculated internal temperature. As described above, in the embodiment, the battery state indicates a deterioration state of a storage enabled electric charge amount, and is calculated on the basis of one of or both of a degree of deterioration due to charge and discharge cycle (hereinafter, referred to as cycle deterioration) and a degree of deterioration due to neglect (hereinafter, referred to as neglected deterioration).

Calculation of a Amount of Charge and Discharge Electric Charge

In the embodiment, in order to obtain the degree of the cycle deterioration, for example, an amount of charge and discharge electric charge that indicates an amount of electric charge that is charged and discharged to and from the secondary battery is used. Therefore, the calculation device 6-5 calculates the amount of charge and discharge electric charge (S14). A deterioration degree at the time of charging and a deterioration degree at the time of discharging are calculated so as to be distinguishable. Therefore, as an amount of charge and discharge electric charge of the measurement round "n", an electric charge amount "$C^C$" at the time of charging and an electric charge amount "$C^D$" at the time of discharging are calculated so as to be distinguishable.

The following equation 5 is an equation that is used to calculate the amount of charge and discharge electric charge. The left side of the equation "$C_n$" in the equation 5 indicates an electric charge amount in the time period "t". In addition, "$\{(I_{n-1}+I_n)/2\}$" represents an average current value in the time period "t". In addition, by multiplying the average current value by the time period "t", electric charge amount "$C_n$" in the time period "t" is approximately calculated. When polarities of "$I_{n-1}$" and "$I_n$" are the same depending on the connection direction of the ammeter, that is, here, when the electric charge amount "$C_n$" is a positive value, it is indicated that the electric charge amount "$C_n$" is an electric charge amount "$C_n^C$" at the time of charging. In addition, when the electric charge amount "$C_n$" is a negative value, it is indicated that the electric charge amount $C_n$ is an electric charge amount "$C_n^D$" at the time of discharging.

$$C_n = (I_{n-1} + I_n) * t/2 \quad \text{(equation 5)}$$

On the other hand, when the polarities of "$I_{n-1}$" and "$I_n$" are different, it is indicated that both of the charging and discharging occur during the time period "t". For example, when "$I_{n-1}$" is a negative value and "$I_n$" is a positive value, each electric charge amount is obtained on the basis of the equation 5'.

$$C_n^D = I_{n-1} * t/2 \quad \text{(equation 5')}$$

$$C_n^C = I_n * t/2 \quad \text{(equation 5')}$$

In addition, when "$I_{n-1}$" is a positive value and "$I_n$" is a negative value, each of the electric charge amounts is obtained on the basis of the equation 5".

$$C_n^D = I_n * t/2 \quad \text{(equation 5'')}$$

$$C_n^C = I_{n-1} * t/2 \quad \text{(equation 5'')}$$

In addition, in order to calculate a deterioration amount, the electric charge amounts "$C_n$" in each of the time periods "t" from the calculation round "a" of the battery state at the previous time to the calculation round "b" that is a target (the electric charge amount "$C^C$" at the time of charging and the electric charge amount "$C^D$" at the time of discharging) become cumulatively combined. The following equation 6 indicates the total of the electric charge amounts "$C_n$" from the calculation round "a" at the previous time to the target calculation round "b". It is noted that, as described above, the electric charge amount "$C^C$" at the time of charging and the electric charge amount "$C^D$" at the time of discharging are combined so as to be distinguishable. In addition, the calculated electric charge amounts are stored in the storage device 6-6 and read out by the calculation device 6-5 as appropriate.

$$\sum_{n=a}^{b} (C_n)$$

(equation 6)

It is noted that, in the embodiment, a degree of cycle deterioration is set as a calculation target. Therefore, the calculation device 6-5 obtains the amount of charge and discharge electric charge. However, the calculation of the amount of charge and discharge electric charge is not need when the degree of cycle deterioration is not calculated. In addition, the calculation method of the amount of charge and discharge electric charge is not limited to such an example. The amount of charge and discharge electric charge may be calculated, for example, by converting the electric charge amount in accordance with information on transmutation of the SOC.

Calculation of the SOC

After that, the calculation device 6-5 calculates an SOC of the secondary battery in order to calculate a degree of neglected deterioration (S15). The SOC indicates, for example, a ratio of a charge state using a storage enabled capacity of initial performance of the secondary battery as a parameter. The SOC may be used for the above-described calculation step of internal resistance (S12). In this case, it is desirable that the calculation of the SOC is performed prior to the calculation of the internal resistance. As described above, it is desirable that the order of the calculation is determined by considering subsequent calculation for which the result of the above-described calculation is used.

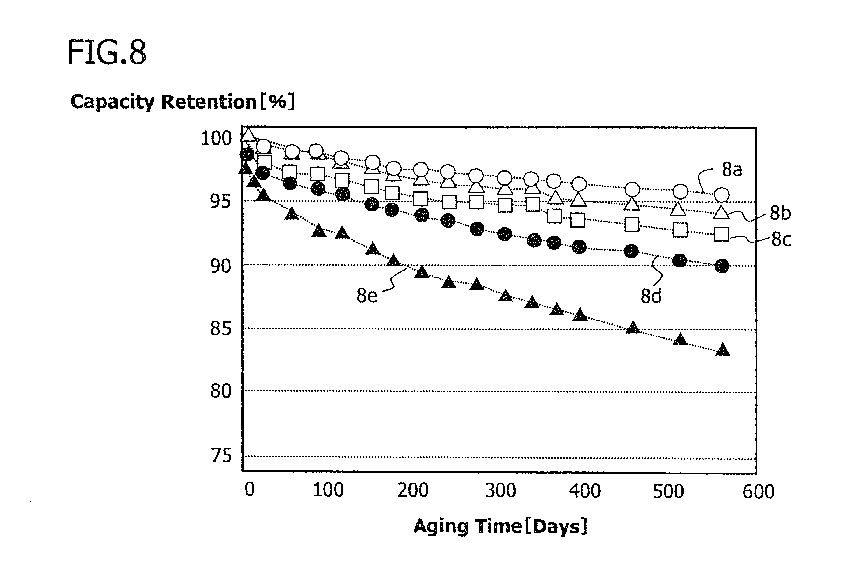

Fig. 8 is a diagram illustrating an example of the effect of SOC, which is given to neglected deterioration. Fig. 8 is quoted from NEDO, Annual Report 2004, "Technological development of lithium battery for FCVs and HEVs". In Fig. 8, the horizontal axis indicates an aging time (day), and the vertical axis indicates a degree of a storage enabled electric charge amount as a degree of neglected deterioration. Curves 8a to 8e in Fig. 8 indicate transmutation of deterioration degrees in cases of SOC 20% to SOC 80%. In particular, the curve 8a indicates a decrease degree of the storage enabled electric charge amount, that is, a degree of neglected deterioration in SOC 20%, the curve 8b indicates a degree of neglected deterioration in SOC 35%, the curve 8c indicates a degree of neglected deterioration SOC 50%, the curve 8d indicates a degree of neglected deterioration in SOC 65%, and the curve 8e indicates a degree of neglected deterioration SOC 80%. In Fig. 8, the degree of neglected deterioration of SOC 80% illustrated in curve 8e is greater than the degree of neglected deterioration of SOC 20% illustrated in the curve 8a. As described above, the degree of neglected deterioration is affected by the SOC. Therefore, in the calculation of the neglected deterioration, the SOC is calculated.

Various methods of calculating an SOC are discussed (for example, Japanese Patent 3919604). In addition, the characteristic of a secondary battery that is mounted on an electric vehicle is different from the characteristic of the secondary battery to which a common method of calculating an SOC is applied. Due to the difference of characteristics, when the common calculation method is used, it is probable that an error occurs in the SOC. Therefore, for example, in a case of a lithium ion battery that is mounted on an electric vehicle, the SOC is calculated by applying an appropriate battery characteristic model to a method using a Kalman filter. For example, the basic concept of the method using the Kalman filter is discussed in P. Lürkens, W. Steffens, Ladezustandsschätzung von BleibatterienmitHilfe des Kalman-Filters, etzArchiv, vol. 8, No. 7, July 1986, pp. 231-236.

In addition, the application of the battery characteristic model is discussed in the papers such as "Domenico Di Domenico et al., 17th IEEE International Conference on Control Applications Part of 2008 IEEE Multi-conference on Systems and Control, p702, 2008", "Zhiwei He et al., Image and Signal Processing, 2009. CISP '09. 2nd International Congress on, p142, 2009", JieXuet al., Image and Signal Processing, 2009. CISP '09. 2nd International Congress on, 2009", "Carmelo Speltino et al., 2010 American Control Conference, p5050, 2010", and "Mori W. Yatsui et al., Vehicle Power and Propulsion Conference (VPPC), 2011.

For example, the calculation device 6-5 according to the embodiment calculates an SOC on the basis of the method using the Kalman filter and stores the SOC in the storage device 6-6. In addition, the SOC includes a characteristic that is changed on the basis of temperature of the secondary battery, and has, for example, a tendency to increase as the temperature increases. Therefore, the calculated SOC is corrected on the basis of the temperature. In particular, when the internal temperature increases, the SOC is corrected so as to be increased on the basis of a measured value, or the like. At this time, as original temperature to be corrected, the internal temperature that is calculated in step S13 may be used. By using the internal temperature for the correction of the SOC, accuracy of the correction is improved, and accuracy of the calculated battery state is also improved.

It is noted that, in the embodiment, the degree of neglected deterioration is set as a calculation target. Therefore, the calculation device 6-5 calculates an SOC. However, the calculation of the SOC is not need when the degree of neglected deterioration is not calculated. In addition, the calculation method of the SOC is not limited to the method of using the Kalman filter.

Calculation of the Deterioration Degree

Next, the calculation device 6-5 calculates a deterioration degree of a storage enabled electric charge amount using the internal temperature, the amount of charge and discharge electric charge, and the SOC (S16). The deterioration degree of the storage enabled electric charge amount in the embodiment is based on deterioration degrees due to neglected deterioration and cycle deterioration. However, as described above, the deterioration degree of the storage enabled electric charge amount may be based on only one of the degreed of neglected deterioration and cycle deterioration.

Calculation of the Neglected Deterioration Degree

First, the calculation device 6-5 calculates a neglected deterioration amount as the degree of neglected deterioration (S161). The neglected deterioration amount is calculated, for example, on the basis of temperature and SOC of the secondary battery. In the embodiment, calculated internal temperature is used as the temperature of the secondary battery.

The following equation 7 indicates a neglected deterioration function $D_H$ that is used to calculate a neglected deterioration amount using a cumulative deterioration amount "$\Sigma D_{n-1}$", the internal temperature "$T_n$", and an SOC "$SOC_n$" as a parameter. Here, the cumulative deterioration amount "$\Sigma D_{n-1}$" is the total (sum) of the neglected deterioration amount and the cycle deterioration amount up to the measurement round "n-1" that is the calculation round "a" at the previous time. The neglected deterioration function "$D_H$" is stored in the storage device 6-6, and read out from the calculation device 6-5, as appropriate. The neglected deterioration amount depends on, for example, the temperature and the SOC. As an example, the neglected deterioration amount has a tendency to increase when the internal temperature is high. In addition, as described above in Fig. 8, as an example, the neglected deterioration amount has a tendency to increase when the SOC is high. In addition, for example, the neglected deterioration amount varies depending on the cumulative deterioration amount "$\Sigma D_{n-1}$". For example, the neglected deterioration amount has a tendency to increase when the cumulative deterioration amount "$\Sigma D_{n-1}$" is small and has a tendency to decrease when the cumulative deterioration amount "$\Sigma D_{n-1}$" is large.

As described above, the deterioration degree of the storage enabled electric charge amount due to neglected deterioration deteriorates depending on the internal temperature and the charge state and depends on the sum of the deterioration degrees. The neglected deterioration function "$D_H$" is calculated beforehand, for example, on the basis of an experiment, or the like in which the cumulative deterioration amount, the internal temperature, and the SOC are changed depending on the type of the secondary battery.

$$D_H \left( \Sigma D_{n-1},\ T_n,\ SOC_n \right) \quad \text{(equation 7)}$$

After that, a neglected deterioration amount from the calculation round "a" of the battery state at the previous time to the calculation round "b" that is a target is calculated on the basis of the following equation 8. In particular, a deterioration amount at the time of calculation is obtained by cumulatively combining neglected deterioration amounts based on the internal temperature and the change state for each of the time periods "t". In the equation 8, for example, the neglected deterioration amount in the calculation round "a" at the previous time is represented as "$D_H(\Sigma D_{a-1}, T_a, SOC_a)*t$", and a neglected deterioration amount in a calculation round "a+1" is represented as "$D_H(\Sigma D_a, T_{a+1}, SOC_{a+1})*t$". In addition, the neglected deterioration amount in the calculation round "b" that is a target is represented as "$D_H(\Sigma D_{b-1}, T_b, SOC_b)*t$". In addition, by combining the neglected deterioration amounts in the time periods "t" from the calculation round "a" to the calculation round "b", the total neglected deterioration amount from the calculation round "a" at the previous time to the calculation round "b" that is a target is calculated.

$$\sum_{n=a}^{b} \{D_H(\Sigma D_{n-1}, T_n, SOC_n) \cdot t\} = D_H(\Sigma D_{a-1}, T_a, SOC_a) \cdot t + D_H(\Sigma D_a, T_{a+1}, SOC_{a+1}) \cdot t + \cdots + D_H(\Sigma D_{b-1}, T_b, SOC_b) \cdot t$$

(equation 8)

It is noted that, in this example, the degree of neglected deterioration is obtained as the neglected deterioration amount, and the embodiment is not limited to such an example. The degree of neglected deterioration may be calculated as a neglected deterioration rate. In this case, by obtaining a neglected deterioration rate in the time period "t" and multiplying the neglected deterioration rates of the respective time periods "t" to each other, the total neglected deterioration rate from the calculation round "a" at the previous time to the calculation round "b" that is a target is calculated.

Calculation of the Cycle Deterioration

After that, the calculation device 6-5 calculates a cycle deterioration amount as the degree of cycle deterioration (S162). The cycle deterioration amount is calculated, for example, on the basis of the temperature of the secondary battery and the amount of charge and discharge electric charges "$C^C$" and "$C^D$". In the embodiment, the internal temperature is calculated as the temperature of the secondary battery is used. In addition, the cycle deterioration amounts at the time of charging and at the time of discharging are calculated so as to be distinguishable.

The following equation 9 indicates a cycle deterioration function "$D_C$" that is used to calculate a cycle deterioration amount at the time of charging, using the cumulative deterioration amount "$\Sigma D_{n-1}$", the internal temperature "$T_n$", and a charge electric charge amount "$C^C_n$" as a parameter. Similarly, a cumulative deterioration amount "$\Sigma D_{n-1}$" indicates the total (sum) of the neglected deterioration amount and the cycle deterioration amount up to the measurement round "n-1" that is the calculation round "a" at the previous time.

$$D_C (\Sigma D_{n-1}, T_n, C^C_n) \quad \text{(equation 9)}$$

In addition, the following equation 10 indicates a cycle deterioration function "$D_D$" that is used to calculate a cycle deterioration amount at the time of discharging, using the cumulative deterioration amount "$\Sigma D_{n-1}$", the internal temperature "$T_n$", and a discharge electric charge amount "$C^D_n$" as a parameter.

$$D_D (\Sigma D_{n-1}, T_n, C^D_n) \quad \text{(equation 10)}$$

The cycle deterioration amount depends on, for example, the temperature and the amount of charge and discharge electric charge. As an example, the cycle deterioration amount has a tendency to increase as the internal temperature decreases, and has a tendency to increase as the amount of charge and discharge electric charge increases. In addition, for example, the cycle deterioration amount varies depending on the cumulative deterioration amount "$\Sigma D_{n-1}$". For example, the cycle deterioration amount has a tendency to increase when the cumulative deterioration amount "$\Sigma D_{n-1}$" is small and has a tendency to decrease when the cumulative deterioration amount "$\Sigma D_{n-1}$" is large.

As described above, the deterioration degree of the storage enabled electric charge amount due to the cycle deterioration deteriorates depending on the internal temperature and the amount of charge and discharge electric charge and depends on the sum of the deterioration degrees. Each of the cycle deterioration functions is obtained beforehand, for example, on the basis of an experiment, or the like in which the cumulative deterioration amount, the internal temperature, the amount of charge and discharge electric charge, and the speed of charge and discharge are changed depending on the type, or the like of the secondary battery. In addition, each of the cycle deterioration functions is stored in the storage device 6-6 and is used so as to be read out from the calculation device 6-5, as appropriate.

After that, a cycle deterioration amount from the calculation round "a" of the battery state at the previous time to the calculation round "b" that is a target is calculated on the basis of the following equation 11. In particular, a deterioration amount at the time of calculation is obtained by cumulatively combining cycle deterioration amounts based on the internal temperature and the amount of charge and discharge electric charge for the time periods "t". In the equation 11, for example, the cycle deterioration amount in the calculation round "a" at the previous time is represented as "$\{D_C(\Sigma D_{a-1}, T_a, C^C_a) + D_D(\Sigma D_{a-1}, T_a, C^D_a)\}*t$", a cycle deterioration amount in the calculation round "a+1" is represented as "$\{D_C(\Sigma D_a, T_{a+1}, C^C_{a+1}) + D_D(\Sigma D_a, T_{a+1}, C^D_{a+1})\}*t$". In addition, a cycle deterioration amount in the calculation round "b" that is a target is represented as "$\{D_C(\Sigma D_{b-1}, T_b, C^C_b) + D_D(\Sigma D_{b-1}, T_b, C^D_b)\}*t$". In addition, by combining cycle deterioration amounts in the time periods "t" from the calculation round "a" to the calculation round "b", the total cycle deterioration amount from the calculation round "a" at the previous time to the calculation round "b" that is a target is calculated.

$$\sum_{n=a}^{b} \left[ \{D_C(\Sigma D_{n-1}, T_n, C^C_n) + D_D(\Sigma D_{n-1}, T_n, C^D_n)\} \cdot t \right] = \\ \{D_C(\Sigma D_{a-1}, T_a, C^C_a) + D_D(\Sigma D_{a-1}, T_a, C^D_a)\} \cdot t + \\ \{D_C(\Sigma D_a, T_{a+1}, C^C_{a+1}) + D_D(\Sigma D_a, T_{a+1}, C^D_{a+1})\} \cdot t + \\ \cdots + \{D_C(\Sigma D_{b-1}, T_b, C^C_b) + D_D(\Sigma D_{b-1}, T_b, C^D_b)\} \cdot t$$

$$(equation\ 11)$$

It is noted that, in this example, the degree of cycle deterioration is obtained as the cycle deterioration amount, and the embodiment is not limited to such an example. The degree of cycle deterioration may be calculated as a cycle deterioration rate. In this case, a cycle deterioration rate in the time period "t" is obtained, and the total cycle deterioration rate from the calculation round "a" at the previous time to the calculation round "b" that is a target is calculated by multiplying the cycle deterioration rates in the respective time periods "t" to each other. It is noted that, a speed of charge and discharge may be used as a parameter at the time of calculation of the cycle deterioration amount.

As described above, in accordance with the steps S161 and 162, the neglected deterioration amount and the cycle deterioration amount from the calculation round "a" of the battery state at the previous time to the calculation round "b" that is a target are calculated. That is, each of the deterioration amounts of the battery state at the time of calculating is calculated. Each of the deterioration amounts in the embodiment is calculated using not the external temperature but the internal temperature, thereby realizing high accuracy as compared to a method using the external temperature.

Calculation of the Total Deterioration Degree

In addition, the calculation device 6-5 calculates the total deterioration amount "$\Delta Q_{a \to b}$" of a storage enabled electric charge amount in accordance with the following equation 12 (S163). The equation 12 is an equation to calculate the total deterioration amount "$\Delta Q_{a \to b}$" from the calculation round "a" to the calculation round "b" by combining the neglected deterioration amounts and combining the cycle deterioration amounts from the calculation round "a" to the calculation round "b". It is noted that, when a neglected deterioration rate and a cycle deterioration rate are calculated, the total deterioration rate is calculated by multiplying the neglected deterioration rate and the cycle deterioration rate each other. In addition, when the battery state is calculated on the basis of one of the neglected deterioration and the cycle deterioration, the calculation device 6-5 regards the corresponding deterioration amount as the total deterioration amount.

$$\Delta Q_{a \to b} = \sum_{n=a}^{b} \{ D_H ( \sum D_{n-1}, T_n, SOC_n) \cdot t \} + \sum_{n=a}^{b} [ \{ D_C ( \sum D_{n-1}, T_n, C^C_n) + D_D ( \sum D_{n-1}, T_n, C^D_n) \} \cdot t ]$$

$$\text{(equation 12)}$$

It is noted that, in the embodiment, as the calculation of the deterioration degree (deterioration amount, deterioration rate, and the like), the method using the deterioration function is described, and the embodiment is not limited to such a method. For example, a table of a deterioration amount in accordance with a parameter value such as internal temperature is prepared beforehand, and a deterioration amount may be obtained on the basis of the table. In addition, as another method of calculating a deterioration degree, for example, a method using an electric charge amount is discussed in Japanese Patent 3919604, and the like, a method using an electric charge amount and battery terminal open voltage is discussed in Japanese Unexamined Patent Application Publication No. 2004-170231, and the like, and a method using discharge depth (SOC) and temperature is discussed in Japanese Patent 4009537, and the like.

Calculation of the Battery State

In addition, the calculation device 6-5 calculates a battery state of the secondary battery on the basis of the calculated deterioration amount of the storage enabled electric charge amount (S17). For example, first, the calculation device 6-5 calculates a storage enabled electric charge amount "$Q_b$" in the calculation round "b" in accordance with the following equation 13. In the step S16, a deterioration amount "$\Delta Q_{a \to b}$" of a storage enabled electric charge amount from the calculation round "a" at the previous time to the calculation round "b" that is a target is calculated. Therefore, by subtracting the deterioration amount "$\Delta Q_{a \to b}$" that is calculated in step S16, from the calculated storage enabled electric charge amount "$Q_a$" in the calculation round "a" at the previous time in accordance with the equation 13, a storage enabled electric charge amount "$Q_b$" in the calculation round "b" that is a target is calculated.

$$Q_b = Q_a - \Delta Q_{a \to b} \quad \text{(equation 13)}$$

In addition, the calculation device 6-5 calculates a ratio "$R_Q$" of the storage enabled electric charge amount in the measurement round "b" to an initial storage enabled electric charge amount of the battery as a battery state of secondary battery in accordance with the following equation 14. In particular, in the equation 14, the ratio "$R_Q$" is calculated by dividing the storage enabled electric charge amount "$Q_b$" in the measurement round "b", which is calculated by the equation 13 by the initial storage enabled electric charge amount "$Q_0$" of the secondary battery.

$$R_Q = Q_b / Q_0 \quad \text{(equation 14)}$$

In the embodiment, as the battery state that is a calculation target, a deterioration degree of the charge enabled electric charge amount is calculated. Alternatively, as the battery state that is a calculation target, a deterioration degree based on the internal resistance may be calculated. The battery state based on the internal resistance is obtained in accordance with the following equation 15. In the equation 15, internal resistance "$Ri_b$" is internal resistance that is calculated in the measurement round "b", and internal resistance "$Ri_0$" is initial internal resistance of the secondary battery. In the equation 15, by dividing the internal resistance "$Ri_b$" in the measurement round "b" by the initial internal resistance "$Ri_0$", a deterioration state "$R_{Ri}$" based on the internal resistance is calculated as the battery state.

$$R_{Ri} = Ri_b / Ri_0 \quad \text{(equation 15)}$$

It is noted that, the value of the internal resistance that is calculated in the step S12 in the flowchart of Fig. 5 may be corrected on the basis of the internal temperature in the embodiment. In this case, for example, the plots of the voltage value and the current value, which are illustrated in Fig. 6 are corrected on the basis of the internal temperature. For example, the internal resistance has a tendency to decrease as the temperature increases. Therefore, for example, the plot of the voltage value and the current value when the internal temperature is high is corrected so that the internal resistance is reduced. As a result, accuracy of the internal resistance is improved, and accuracy of the calculated battery state (deterioration state based on the internal resistance) is also improved.

As described above, the state evaluation apparatus 10 of the secondary battery according to the embodiment calculates internal resistance on the basis of the measured voltage value and current value of the secondary battery, and calculates the internal temperature of the secondary battery on the basis of the current value, the internal resistance, and the measured external temperature of the secondary battery. In addition, the state evaluation apparatus 10 obtains a charge state that indicates an amount of charge and discharge electric charge of the secondary battery based on the current value or a charging rate of the secondary battery based on the current value and the voltage value, and calculates a battery state that indicates a state after deterioration of the secondary battery, on the basis of at least one of the amount of charge and discharge electric charge and the charge state, and the internal temperature. As described above, the state evaluation apparatus 10 according to the embodiment calculates battery internal temperature to be estimated and can calculate a battery state highly accurately.

In particular, when a battery state of a secondary battery that is mounted on an electric vehicle is calculated, current in the secondary battery varies greatly. For example, when the electric vehicle is traveling, it is assumed that large current of 100A or more flows in a short space of a time within a unit of one second. At this time, temperature rise of about 10°C or more is predicted inside of the secondary battery. On the other hand, a rapid temperature rise of the surface of the secondary battery when the current flows barely occurs on the basis of the heat capacity, the shape, and the dimension. Therefore, when a battery state is calculated using the surface temperature based on the thermometer that is installed outside the battery, for example, by using the surface temperature that is different from the internal temperature of the battery by 10°C or more, the error between the calculated battery state and the actual battery state becomes large. The estimated life of the secondary battery that is used for the electric vehicle is, for example, about five years to 10 years. Therefore, it is probable that there is a problem that the error between the battery states becomes large.

As described above, when the secondary battery is mounted in an environment in which current is changed rapidly in a short space of a time, a difference between the internal temperature and the surface temperature of the battery becomes large easily. Therefore, the state evaluation apparatus 10 according to the embodiment calculates internal temperature using first internal temperature change based on internal Joule heat of the secondary battery, which is obtained on the basis of the current value and the internal resistance, and second internal temperature change based on the heat transfer due to the temperature difference between the inside and outside of the secondary battery. As described above, by considering the rise of the internal temperature based on the Joule heat, and decrease in the internal temperature (when the external temperature of the battery is lower than the internal temperature) or increase in the internal temperature (when the external temperature of the battery is higher than the internal temperature) based on the heat transfer due to the temperature difference between the inside and outside of the secondary battery, the internal temperature can be calculated. As a result, the internal temperature to be estimated can be calculated on the basis of the current value, the external temperature, and the internal resistance based on the current value and voltage value.

In addition, the state evaluation apparatus 10 obtains the first internal temperature change by multiplying a product of the square of the current value and the internal resistance by a set coefficient. As a result, the first internal temperature change can be highly accurately calculated on the basis of a characteristic of the secondary battery that is a target. In addition, the state evaluation apparatus 10 obtains the second internal temperature change on the basis of a characteristic in which a temperature difference between the inside and outside of the secondary battery exponentially varies for a time using the Napier's constant as a base. As a result, the second internal temperature change can be highly accurately calculated on the basis of the characteristic in which the temperature difference exponentially decreases for a time.

In addition, the state evaluation apparatus 10 of the secondary battery according to the embodiment calculates, for each set time period, internal temperature on the basis of a voltage value, a current value, and external temperature that are measured for each of the set time periods. In addition, the state evaluation apparatus 10 of the secondary battery calculates internal temperature in the set time period at this time (measurement round "n" in the embodiment) by adding the internal temperature change that is calculated in the set time period at this time to the internal temperature that is calculated in the set time period at the previous time (measurement round "n-1" in the embodiment). As a result, the internal temperature of the calculation target round is calculated using the internal temperature at the previous time as the original, so that the internal temperature can be calculated further highly accurately.

As described above, in the state evaluation apparatus 10 according to the embodiment, internal temperature in which the error with actual internal temperature is small can be calculated, and accuracy of the calculated battery state is improved. It is noted that the error between the actual internal temperature and the internal temperature that is calculated by the state evaluation apparatus 10 according to the embodiment can be dealt with by appropriately adjusting the coefficient "α" and the coefficient "β" that are used to calculate the internal temperature. As a result, the error between the actual internal temperature and the calculated internal temperature becomes small, and accuracy of the battery state is improved.

In addition, the internal temperature that is calculated by the state evaluation apparatus 10 according to the embodiment indicates temperature of one of or the combination of the active material in the positive electrode and the negative electrode of the secondary battery, and the electrolyte of the secondary battery. For example, in the lithium ion the secondary battery, deterioration of the battery state occurs when lithium ion that can be generated is reduced. Therefore, it is desirable that the battery state is calculated on the basis of temperature (internal temperature) of the active material in the positive electrode and the negative electrode and the electrolyte inside the battery, which are portions in which the deterioration occurs. The state evaluation apparatus 10 according to the embodiment estimates and calculates the temperature of one of or the combination of the active material in the positive electrode and the negative electrode of the secondary battery and the electrolyte of the secondary battery, so that the battery state can be calculation highly accurately.

It is noted that the state evaluation processing of the secondary battery according to the embodiment may be stored in a computer-readable storage medium as a program and executed by reading the program by a computer.

**Claims**

1. A state evaluation apparatus (10) of a secondary battery (LB), the state evaluation apparatus comprising:

   at least one processor configured to perform a process including:

   calculating (51) internal resistance (Ri) based on a measured voltage value and current value (I) of the secondary battery;
   calculating (52) internal temperature of the secondary battery ($T_n$) based on the current value, the internal resistance, and measured external temperature of the secondary battery (Ts);
   obtaining (53,54) an amount of charge and discharge electric charge of the secondary battery ($\Sigma C_n$) based on the current value, or obtaining a charge state (SOC) that indicates a charging rate of the secondary battery based on the current value and the voltage value; and
   calculating (55,56) a battery state ($R_Q$) that indicates a state after deterioration of the secondary battery, based on the internal temperature and at least one of the amount of charge and discharge electric charge and the charge state.

2. The state evaluation apparatus of the secondary battery, according to claim 1, wherein
   in the calculating of the internal temperature, the internal temperature is calculated using first internal temperature change (equation 2) based on internal Joule heat of the secondary battery, which is obtained based on the current value and the internal resistance, and second internal temperature change (equation 3) based on heat transfer due to a temperature difference between the inside and outside of the secondary battery.

3. The state evaluation apparatus of the secondary battery, according to claim 2, wherein
   the first internal temperature change is obtained by multiplying a product of a square of the current value and the internal resistance by a set coefficient (α).

4. The state evaluation apparatus of the secondary battery, according to claim 2, wherein
   the second internal temperature change is obtained based on a characteristic in which the temperature difference between the inside and outside of the secondary battery exponentially varies for a time using a Napier's constant as a base.

5. The state evaluation apparatus of the secondary battery, according to claim 2, wherein
   in the calculating of the internal temperature, the internal temperature is, for each set time period (t), calculated based on the voltage value, the current value, and the external temperature that are measured for each of the set time periods, and calculates the internal temperature in the set time period at this time by adding internal temperature change that is calculated in the set time period at this time to the internal temperature ($T_{n-1}$) that is calculated in the set time period at a previous time.

6. The state evaluation apparatus of the secondary battery, according to claim 1, wherein the charge state is obtained based on the internal temperature using a Kalman filter.

7. The state evaluation apparatus of the secondary battery, according to claim 1, wherein the battery state of the secondary battery is one of or both of a first battery state that indicates a deterioration degree of a storage enabled electric charge amount of the secondary battery, which deteriorates depending on the internal temperature and the charge state and depends on a sum of deterioration degrees, and a second battery state that indicates a deterioration degree of a storage enabled electric charge amount of the secondary battery, which deteriorates depending on the internal temperature and the amount of charge and discharge electric charge and depends on the sum of the deterioration degrees.

8. The state evaluation apparatus of the secondary battery, according to claim 7, wherein the first battery state indicates a total of the deterioration degrees of the storage enabled electric charge amount based on the internal temperature that is calculated for each set time period and the charge state in the set time period, and
the second battery state indicates a total of the deterioration degrees of the storage enabled electric charge amount based on the internal temperature that is calculated for each of the set time periods and the amount of charge and discharge electric charge in the set time period.

9. The state evaluation apparatus of the secondary battery, according to claim 7, wherein The deterioration degree of the storage enabled electric charge amount in the secondary battery is represented as a ratio of a storage enabled electric charge amount at the time of calculation to an initial storage enabled electric charge amount of the secondary battery ($Q_0$).

10. The state evaluation apparatus of the secondary battery, according to claim 1, wherein the internal temperature is temperature of one of or combination of an active material in a positive electrode and negative electrode of the secondary battery, and an electrolyte of the secondary battery.

11. The state evaluation apparatus of the secondary battery, according to claim 1, wherein the external temperature is one of temperature of a surface of the secondary battery and a temperature near the surface.

12. The state evaluation apparatus of the secondary battery, according to claim 1, wherein the calculated internal resistance is corrected depending on the internal temperature calculated at the previous time.

13. A state evaluation method of a secondary battery, the state evaluation method comprising:

    calculating internal resistance based on a measured voltage value and current value of the secondary battery;
    calculating internal temperature of the secondary battery based on the current value, the internal resistance, and measured external temperature of the secondary battery;
    obtaining an amount of charge and discharge electric charge of the secondary battery based on the current value, or obtaining a charge state that indicates a charging rate of the secondary battery based on the current value and the voltage value; and
    calculating a battery state of the secondary battery based on the internal temperature and at least one of the amount of charge and discharge electric charge and the charge state.

14. The state evaluation method of a secondary battery, according to claim 13, wherein in the calculation of the internal temperature, the internal temperature is calculated using first internal temperature change based on internal Joule heat of the secondary battery, which is obtained based on the current value and the internal resistance, and second internal temperature change based on heat transfer due to a temperature difference between the inside and outside of the secondary battery.

15. A computer-readable state evaluation program of a secondary battery, which causes a computer to executes state evaluation processing of the secondary battery, the state evaluation processing comprising:

    calculating internal resistance based on a measured voltage value and current value of the secondary battery;
    calculating internal temperature of the secondary battery based on the current value, the internal resistance, and measured external temperature of the secondary battery;

obtaining an amount of charge and discharge electric charge of the secondary battery based on the current value, or obtaining a charge state that indicates a charging rate of the secondary battery based on the current value and the voltage value; and

calculating a battery state of the secondary battery based on the internal temperature and at least one of the amount of charge and discharge electric charge and the charge state.

FIG.1

10

6-6 STORAGE DEVICE

6-5 CALCULATION DEVICE

6-7 EXTERNAL INPUT/ OUTPUT DEVICE

6-8 EXTERNAL DEVICE

6-4 MEASUREMENT DEVICE

LB SECONDARY BATTERY

# FIG.2

CURRENT SENSOR  6-2

LB | SECONDARY BATTERY

LB | SECONDARY BATTERY

LB | SECONDARY BATTERY

LOAD

LB | SECONDARY BATTERY

LB | SECONDARY BATTERY

LB | SECONDARY BATTERY

VOLTAGE SENSOR  6-1

TEMPERATURE SENSOR  6-3

VOLTAGE SENSOR  6-1

TEMPERATURE SENSOR  6-3

MEASUREMENT DEVICE  6-4

STORAGE DEVICE  6-6

CALCULATION DEVICE  6-5

EXTERNAL INPUT/OUTPUT DEVICE  6-7

EXTERNAL DEVICE  6-8

STORAGE DEVICE  6-9

10

EP 2 713 433 A1

FIG.3

CURRENT    VOLTAGE    SURFACE TEMPERATURE

6-5

INTERNAL RESISTANCE CALCULATION UNIT — 51

CHARGE/DISCHARGE ELECTRIC CHARGE AMOUNT CALCULATION UNIT — 54

BATTERY INTERNAL TEMPERATURE CALCULATION UNIT — 52

SOC CALCULATION UNIT — 53

DETERIORATION AMOUNT CALCULATION UNIT — 55

BATTERY STATE CALCULATION UNIT — 56

EP 2 713 433 A1

EP 2 713 433 A1

FIG.4

# FIG.5

```
S11
PERFORM MEASUREMENT
  ┌──────────────────────┐
  │ MEASURE VOLTAGE,     │ ·······> STORAGE DEVICE  6-6
  │ CURRENT, AND         │
  │ SURFACE TEMPERATURE  │
  └──────────────────────┘
           │
           ▼
  ┌──────────────────────┐
  │ PERFORM              │
  │ A/D CONVERSION       │
  └──────────────────────┘
```

S12 CALCULATE INTERNAL RESISTANCE ·······> STORAGE DEVICE 6-6

S13 ESTIMATE TEMPERATURE
- S131 CALCULATE HEAT GENERATION TEMPERATURE
- S132 CALCULATE HEAT TRANSFER TEMPERATURE ·······> STORAGE DEVICE 6-6
- S133 CALCULATE INTERNAL TEMPERATURE

S14 CALCULATE ELECTRIC CHARGE AMOUNT ·······> STORAGE DEVICE 6-6

S15 CALCULATE SOC ·······> STORAGE DEVICE 6-6

S16 CALCULATE DETERIORATION AMOUNT
- S161 CALCULATE NEGLECTED DETERIORATION AMOUNT
- S162 CALCULATE CYCLE DETERIORATION AMOUNT ·······> STORAGE DEVICE 6-6
- S163 CALCULATE TOTAL DETERIORATION AMOUNT

S17 CALCULATE BATTERY STATE ·······> STORAGE DEVICE 6-6

# FIG.6

# FIG.7

TEMPERATURE

$T_{n-1} + \Delta T^H_{n-1 \rightarrow n}/2$

LT

$(Ts_{n-1} + Ts_n)/2$

$t=0$

$t=\infty$

$t$

EP 2 713 433 A1

# FIG.8

**Capacity Retention[%]**

EP 2 713 433 A1

Europäisches
Patentamt

European
Patent Office

Office européen
des brevets

# EUROPEAN SEARCH REPORT

Application Number

EP 13 18 5515

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2011/045853 A1 (HITACHI LTD [JP]; HITACHI VEHICLE ENERGY LTD [JP]; KAWAHARA YOUHEI [JP]) 21 April 2011 (2011-04-21) * the whole document * * & US 2012/256569 A1 (KAWAHARA YOUHEI [JP] ET AL) 11 October 2012 (2012-10-11) * the whole document * * * in particular: * * paragraphs [0050], [0055], [0056], [0071] * | 1-15 | INV. H01M10/48 G01R31/36 |
| X | US 2012/209551 A1 (TAKAHASHI KENJI [JP] ET AL) 16 August 2012 (2012-08-16) * claims 1,2,6 * | 1-15 | |
| Y | JP 2010 019705 A (AUTONETWORKS TECHNOLOGIES LTD; SUMITOMO WIRING SYSTEMS; SUMITOMO ELECT) 28 January 2010 (2010-01-28) * abstract * * paragraph [0033] * | 1,2,4,6, 13,15 | |
| | | | TECHNICAL FIELDS SEARCHED (IPC) |
| Y | US 2011/299564 A1 (LEUTHEUSER ANDREW H [US] ET AL) 8 December 2011 (2011-12-08) * claim 11 * | 1,2,4,6, 13,15 | H01M G01R B60L |

The present search report has been drawn up for all claims

| Place of search | Date of completion of the search | Examiner |
|---|---|---|
| The Hague | 29 January 2014 | Standaert, Frans |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

EP 2 713 433 A1

**ANNEX TO THE EUROPEAN SEARCH REPORT
ON EUROPEAN PATENT APPLICATION NO.** EP 13 18 5515

This annex lists the patent family members relating to the patent documents cited in the above-mentioned European search report.
The members are as contained in the European Patent Office EDP file on
The European Patent Office is in no way liable for these particulars which are merely given for the purpose of information.

29-01-2014

| Patent document cited in search report | | Publication date | Patent family member(s) | | Publication date |
|---|---|---|---|---|---|
| WO 2011045853 | A1 | 21-04-2011 | CN | 102576914 A | 11-07-2012 |
| | | | US | 2012256569 A1 | 11-10-2012 |
| | | | WO | 2011045853 A1 | 21-04-2011 |
| US 2012209551 | A1 | 16-08-2012 | CN | 102792175 A | 21-11-2012 |
| | | | JP | 4775524 B1 | 21-09-2011 |
| | | | US | 2012209551 A1 | 16-08-2012 |
| | | | WO | 2012046266 A1 | 12-04-2012 |
| JP 2010019705 | A | 28-01-2010 | JP | 5073601 B2 | 14-11-2012 |
| | | | JP | 2010019705 A | 28-01-2010 |
| US 2011299564 | A1 | 08-12-2011 | CN | 102331314 A | 25-01-2012 |
| | | | DE | 102011102360 A1 | 29-12-2011 |
| | | | US | 2011299564 A1 | 08-12-2011 |

EPO FORM P0459

For more details about this annex : see Official Journal of the European Patent Office, No. 12/82

28

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 4009537 B
- JP 4548011 B
- JP 3919604 B
- JP 2004170231 A

**Non-patent literature cited in the description**

- **P. LÜRKENS ; W. STEFFENS.** Ladezustandsschätzung von BleibatterienmitHilfe des Kalman-Filters. *etzArchiv,* July 1986, vol. 8 (7), 231-236
- **DOMENICO DI DOMENICO et al.** 17th IEEE International Conference on Control Applications. *2008 IEEE Multi-conference on Systems and Control,* 2008, 702
- **ZHIWEI HE et al.** *Image and Signal Processing, 2009. CISP '09. 2nd International Congress on,* 2009, 142
- **JIEXUET.** *Image and Signal Processing, 2009. CISP '09. 2nd International Congress on,* 2009
- **CARMELO SPELTINO et al.** *2010 American Control Conference,* 2010, 5050
- **MORI W. YATSUI et al.** *Vehicle Power and Propulsion Conference (VPPC,* 2011